# EUROPEAN PATENT APPLICATION

(11) **EP 4 780 161 A1**
(43) Date of publication of application: **22.07.2026**
(21) Application number: 25194486.4
(22) Date of filing: 07.08.2025
(51) Int. Cl.: H10D 30/01, H10D 30/47, H10D 64/00, H10D 30/69, H10D 64/27, H10D 64/01, H10D 30/00

(54) **SEMICONDUCTOR DEVICE AND METHOD OF MANUFACTURING THE SAME**

(30) Priority: 16.01.2025 KR 20250006821
(71) Applicant: SAMSUNG ELECTRONICS CO., LTD., Yeongtong-gu Suwon-si, Gyeonggi-do 16677 (KR)
(72) Inventor: KANG, Sangmin, 16677 Suwon-si, Gyeonggi-do (KR); JEONG, MinYong, 16677 Suwon-si, Gyeonggi-do (KR); KOH, Jaekang, 16677 Suwon-si, Gyeonggi-do (KR); KWON, Uihui, 16677 Suwon-si, Gyeonggi-do (KR); MA, Jinwon, 16677 Suwon-si, Gyeonggi-do (KR); YANG, Suk, 16677 Suwon-si, Gyeonggi-do (KR)
(74) Representative: Kuhnen & Wacker Patent- und Rechtsanwaltsbüro PartG mbB

(57) **Abstract**

A semiconductor device includes a substrate including an active pattern, first and second semiconductor patterns vertically spaced apart from each other on the active pattern, a gate electrode between the first and second semiconductor patterns, a gate insulating pattern surrounding the gate electrode, and a thin layer structure in the gate electrode, wherein the thin layer structure is surrounded by the gate electrode, and the thin layer structure is spaced apart from the gate insulating pattern.

## Description

### CROSS-REFERENCE TO RELATED APPLICATIONS

This U.S. non-provisional patent application claims priority under 35 U.S.C.§119 to Korean Patent Application No. 10-2025-0006821 filed on January 16, 2025, in the Korean Intellectual Property Office, the entire contents of which are hereby incorporated by reference.

### BACKGROUND

The inventive concepts relate to semiconductor devices and/or methods of manufacturing the same, and more specifically, relate to semiconductor devices including a field effect transistor and/or methods of manufacturing the same.

A semiconductor device may include an integrated circuit including metal-oxide-semiconductor field effect transistors (MOSFETs). As sizes and design rules of semiconductor devices have been reduced, sizes of MOSFETs have also been scaled down. Operating characteristics of semiconductor devices may be deteriorated by the scale down of the MOSFETs. Thus, various researches are being conducted for semiconductor devices capable of overcoming limitations caused by a high integration density and/or of improving performance.

### SUMMARY

Some example embodiments of the inventive concepts provide semiconductor devices with improved electrical characteristics and methods of manufacturing the same.

The problems to be solved by the inventive concepts are not limited to the problems mentioned above, and other problems not mentioned may be clearly understood by a person having ordinary skill in the art from the description below.

A semiconductor device according to some example embodiments of the inventive concepts may include a substrate including an active pattern, first and second semiconductor patterns vertically spaced apart from each other on the active pattern, a gate electrode between the first and second semiconductor patterns, a gate insulating pattern surrounding the gate electrode, and a thin layer structure in the gate electrode, wherein the thin layer structure is surrounded by the gate electrode, and the thin layer structure is spaced apart from the gate insulating pattern.

A semiconductor device according to some example embodiments of the inventive concepts may include a substrate including an active pattern, first and second semiconductor patterns vertically spaced apart from each other on the active pattern, a gate electrode between the first and second semiconductor patterns, the gate electrode including a plurality of gate electrodes, a gate spacer between the plurality of gate electrodes, a gate insulating pattern surrounding the gate electrode, and a thin layer structure in the gate electrode, wherein the thin layer structure is spaced apart from the gate spacer and the gate insulating pattern.

A semiconductor device according to some example embodiments of the inventive concepts may include a substrate including an active pattern, first and second semiconductor patterns vertically spaced apart from each other on the active pattern, a gate electrode between the first and second semiconductor patterns, the gate electrode extending in a first direction parallel to an upper surface of the substrate, the gate electrode including a plurality of gate electrodes, a gate spacer between the plurality of gate electrodes, a gate capping pattern on the gate electrode, a gate insulating pattern surrounding the gate electrode, and a thin layer structure in the gate electrode, wherein the thin layer structure is spaced apart from the gate spacer and the gate insulating pattern.

A method of manufacturing semiconductor device according to some example embodiments of the inventive concepts may include forming a stacked pattern including semiconductor channels and sacrificial layers alternately stacked, forming a gate spacer on the stacked pattern, forming recesses in the stacked pattern, forming source/drain patterns in the recesses, removing the sacrificial layers and the gate spacer to expose the first and second semiconductor patterns, sequentially forming a gate insulating pattern and a gate electrode on the exposed surfaces of the first and second semiconductor patterns, and forming a thin film structure in the gate electrode, wherein the gate electrode is formed to partially fill an inner region where the sacrificial layers are removed, and the forming of the thin film structure includes filling the remainder of the inner region after the gate electrode is formed with the thin layer structure.

### BRIEF DESCRIPTION OF THE DRAWINGS

Example embodiments will be more clearly understood from the following brief description taken in conjunction with the accompanying drawings. The accompanying drawings represent non-limiting, example embodiments as described herein.
FIGS. 1 to 3 are conceptual diagrams for explaining logic cells of a semiconductor device according to some example embodiments of the inventive concepts.
FIG. 4 is a plan view for explaining a semiconductor device according to an example embodiment of the inventive concepts.
FIGS. 5A to 5D are cross-sectional views taken along lines A-A', B-B', C-C', and D-D' of FIG. 4, respectively.
FIG. 6A is an enlarged view corresponding to portion 'E1' of FIG. 5A.
FIG. 6B is an enlarged view corresponding to portion 'E2' of FIG. 5D.
FIG. 7A is a plan view for explaining a semiconductor device according to an example embodiment of the inventive concepts.
FIG. 7B is a cross-sectional view along line D-D' of FIG. 7A.
FIGS. 8A to 15B are cross-sectional views showing a method of manufacturing a semiconductor device according to an example embodiment of the inventive concepts.

### DETAILED DESCRIPTION

Hereinafter, to explain the inventive concepts in detail, some example embodiments according to the inventive concepts will be described with reference to the attached drawings.

As used herein, expressions such as "one of," "one or more of," "any one of," "at least one of," and "at least one selected from" when preceding a list of elements, modify the entire list of elements and do not modify the individual elements of the list. Thus, for example, both "at least one of A, B, or C" and "at least one of A, B, and C" mean either A, B, C or any combination thereof. Likewise, A and/or B means A, B, or A and B.

While the term "same," "equal" or "identical" is used in description of example embodiments, it should be understood that some imprecisions may exist. Thus, when one element is referred to as being the same as another element, it should be understood that an element or a value is the same as another element within a desired manufacturing or operational tolerance range (e.g., ±10%).

When the term "about," "substantially" or "approximately" is used in this specification in connection with a numerical value, it is intended that the associated numerical value includes a manufacturing or operational tolerance (e.g., ±10%) around the stated numerical value. Moreover, when the word "about," "substantially" or "approximately" is used in connection with geometric shapes, it is intended that precision of the geometric shape is not required but that latitude for the shape is within the scope of the disclosure. Further, regardless of whether numerical values or shapes are modified as "about" or "substantially," it will be understood that these values and shapes should be construed as including a manufacturing or operational tolerance (e.g., ±10%) around the stated numerical values or shapes.

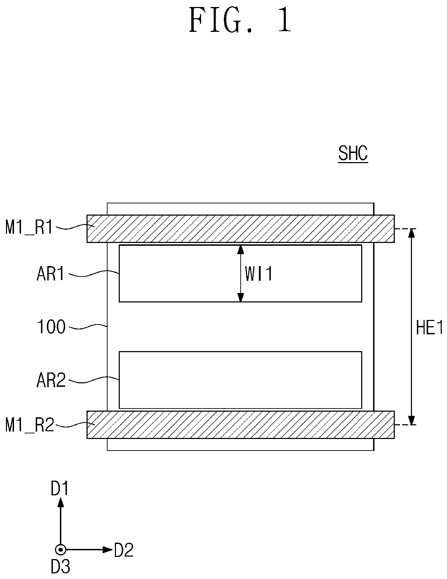

FIGS. 1 to 3 are conceptual diagrams for explaining logic cells of semiconductor devices according to some example embodiments of the inventive concepts.

Referring to FIG. 1, a single height cell SHC may be provided. For example, a substrate 100 may be provided thereon with a first power line M1_R1 and a second power line M1_R2. The first power line M1_R1 may be a path for providing a source voltage VSS, for example, a ground voltage. The second power line M1_R2 may be a path for providing a drain voltage VDD, for example, a power voltage.

The single height cell SHC may be defined between the first power line M1_R1 and the second power line M1_R2. The single height cell SHC may include one first active region AR1 and one second active region AR2. One of the first and second active regions AR1 and AR2 may be a PMOSFET region, and the other of the first and second active regions AR1 and AR2 may be an NMOSFET region. For example, the single height cell SHC may have a complementary metal oxide semiconductor (CMOS) structure provided between the first power line M1_R1 and the second power line M1_R2.

Each of the first and second active regions AR1 and AR2 may have a first width WI1 in a first direction D1. A first height HE1 may indicate a length in the first direction D1 of the single height cell SHC. The first height HE1 may be the same as or substantially similar to a distance (e.g., pitch) between the first power line M1_R1 and the second power line M1_R2.

The single height cell SHC may constitute one logic cell. In this description, the logic cell may be a logic device, such as AND, OR, XOR, XNOR, and inverter, that performs a specific function. For example, the logic cell may include transistors for constituting a logic device and may also include wiring lines that connect the transistors to each other.

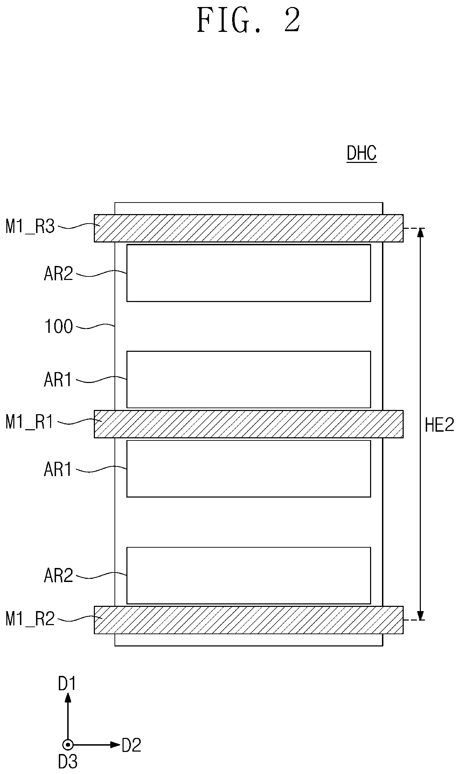

Referring to FIG. 2, a double height cell DHC may be provided. For example, a substrate 100 may be provided thereon with a first power line M1_R1, a second power line M1_R2, and a third power line M1_R3. The first power line M1_R1 may be disposed between the second power line M1_R2 and the third power line M1_R3. The third power line M1_R3 may be a path for providing a source voltage VSS.

The double height cell DHC may be between the second power line M1_R2 and the third power line M1_R3. The double height cell DHC may include two first active regions AR1 and two second active regions AR2.

One of the two second active regions AR2 may be adjacent to the second power line M1_R2. The other of the two second active regions AR2 may be adjacent to the third power line M1_R3. The two first active regions AR1 may be adjacent to the first power line M1_R1. When viewed in a plan, the first power line M1_R1 may be disposed between the two first active regions AR1.

A second height HE2 may indicate a length in the first direction D1 of the double height cell DHC. The second height HE2 may be about twice the first height HE1 of FIG. 1. The two first active regions AR1 of the double height cell DHC may be integrally connected to each other to serve as one active region.

In the inventive concepts, the double height cell DHC shown in FIG. 2 may be referred to as a multi-height cell. Although not shown, the multi-height cell may include a triple height cell whose cell height is about three times that of the single height cell SHC.

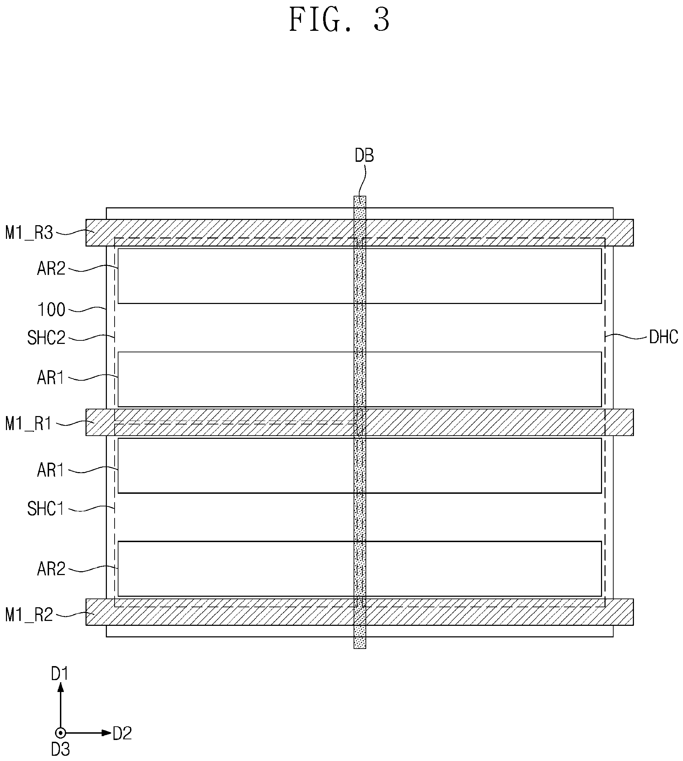

Referring to FIG. 3, a substrate 100 may be provided thereon with a first single height cell SHC1, a second single height cell SHC2, and a double height cell DHC that are two-dimensionally disposed. The first single height cell SHC1 may be disposed between a first power line M1_R1 and a second power line M1_R2. The second single height cell SHC2 may be disposed between the first power line M1_R1 and a third power line M1_R3. The second single height cell SHC2 may be adjacent in a first direction D1 to the first single height cell SHC1.

The double height cell DHC may be disposed between the second power line M1_R2 and the third power line M1_R3. The double height cell DHC may be adjacent in a second direction D2 to the first and second single height cells SHC1 and SHC2.

A separation structure DB may be provided between the first single height cell SHC1 and the double height cell DHC and between the second single height cell SHC2 and the double height cell DHC. The separation structure DB may electrically separate an active region of the double height cell DHC from an active region of each of the first and second single height cells SHC1 and SHC2.

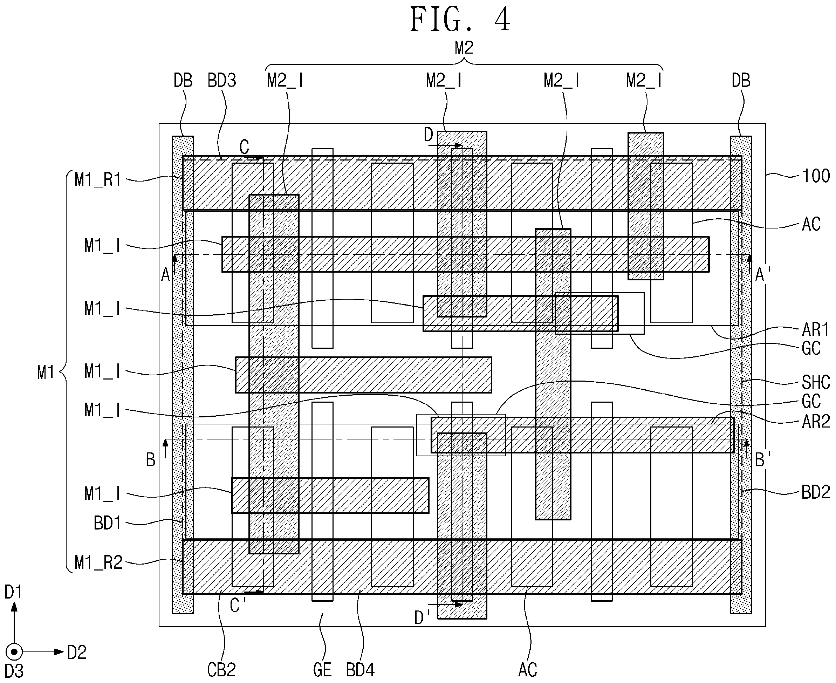

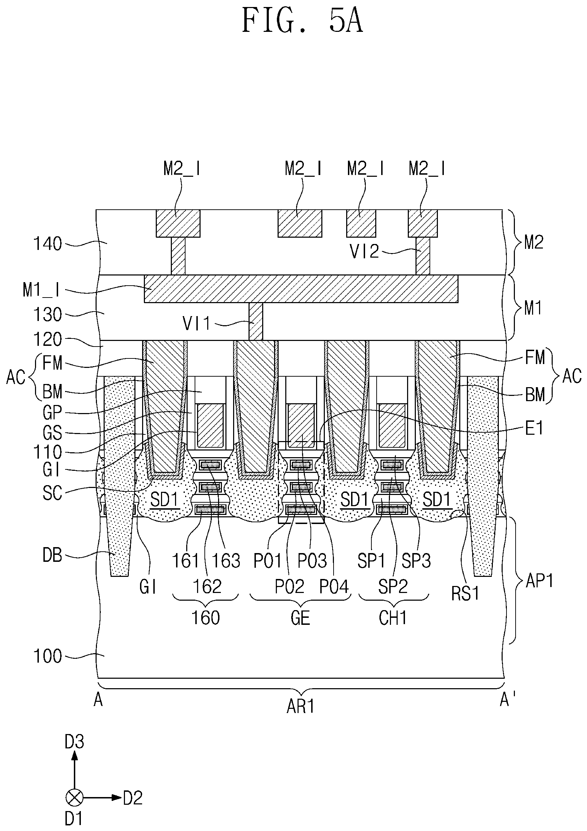

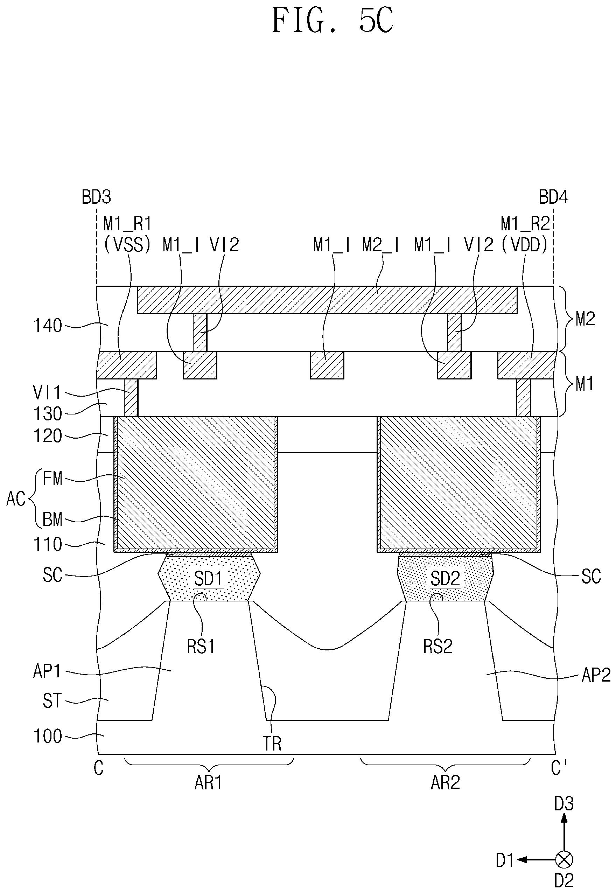

FIG. 4 is a plan view for explaining a semiconductor device according to an example embodiment of the inventive concepts. FIGS. 5A to 5D are cross-sectional views taken along lines A-A', B-B', C-C', and D-D' of FIG. 4, respectively.

The semiconductor devices illustrated in FIGS. 4 and 5A to 5D are examples that more specifically illustrate the single height cell SHC of FIG. 1. Referring to FIGS. 4 and 5A to 5D, a single height cell SHC may be provided on a substrate 100. The single height cell SHC may be provided on the substrate 100 with logic transistors included in a logic circuit. The substrate 100 may be a compound semiconductor substrate or a semiconductor substrate including, for example, silicon, germanium, or silicon-germanium. For example, the substrate 100 may be a silicon substrate.

The substrate 100 may include a first active region AR1 and a second active region AR2. Each of the first and second active regions AR1 and AR2 may extend in a second direction D2. The first active region AR1 may be one of NMOSFET region and PMOSFET region and the second active AR2 may be the other one of NMOSFET region and PMOSFET region. In an example embodiment, the first active region AR1 may be a NMOSFET region, and the second active region AR2 may be an PMOSFET region.

A first active pattern AP1 and a second active pattern AP2 may be defined by a trench TR that is formed on an upper portion of the substrate 100. The first active pattern AP1 may be provided on the first active region AR1, and the second active pattern AP2 may be provided on the second active region AR2. The first and second active patterns AP1 and AP2 may extend in the second direction D2. The first and second active patterns AP1 and AP2 may be vertically protruding portions of the substrate 100.

A device isolation layer ST may be provided on the substrate 100. The device isolation layer ST may fill the trench TR. The device isolation layer ST may include, for example, a silicon oxide layer. The device isolation layer ST might not cover any of first and second channel patterns CH1 and CH2 which will be discussed below.

A first channel pattern CH1 may be provided on the first active pattern AP1. A second channel pattern CH2 may be provided on the second active pattern AP2. Each of the first and second channel patterns CH1 and CH2 may include a first semiconductor pattern SP1, a second semiconductor pattern SP2, and a third semiconductor pattern SP3 that are sequentially stacked on each other. The first, second, and third semiconductor patterns SP1, SP2, and SP3 may be spaced apart from each other in a vertical direction (e.g., a third direction D3).

The first to third semiconductor patterns SP1, SP2, and SP3 may include a two-dimensional material (2D material). For example, each of the first to third semiconductor patterns SP1, SP2, and SP3 may include at least one of graphene, a transition metal chalcogenide, black phosphorus, or a two-dimensional oxide. For example, each of the first to third semiconductor patterns SP1, SP2, and SP3 may include MoS2, WSe2, or MoTe2. The two-dimensional material included in the first to third semiconductor patterns SP1, SP2, and SP3 may be doped with an N-type conductive material or may be doped with a P-type conductive material. The N-type conductive material may include, for example, phosphorus (P), arsenic (As), antimony (Sb), or bismuth (Bi). The P-type conductive material may include, for example, boron (B), aluminum (Al), indium (In), or gallium (Ga).

A plurality of first source/drain patterns SD1 may be provided on the first active pattern AP1. A plurality of first recesses RS1 may be formed on an upper portion of the first active pattern AP1. The first source/drain patterns SD1 may be provided in the first recesses RS1, respectively. The first source/drain patterns SD1 may be impurity regions of the first conductive type. The first channel pattern CH1 may be interposed between a pair of first source/drain patterns SD1. For example, the stacked first to third semiconductor patterns SP1, SP2, and SP3 may connect a pair of first source/drain patterns SD1 to each other.

A plurality of second source/drain patterns SD2 may be provided on the second active pattern AP2. A plurality of second recesses RS2 may be formed on an upper portion of the second active pattern AP2. The second source/drain patterns SD2 may be provided in the second recesses RS2, respectively. The second source/drain patterns SD2 may be second conductive type impurity regions. The second channel pattern CH2 may be interposed between the pair of second source/drain patterns SD2. For example, the stacked first to third semiconductor patterns SP1, SP2, and SP3 may connect a pair of second source/drain patterns SD2 to each other.

The first conductivity type of the first source/drain pattern SD1 may be one of n-type or p-type, and the second conductivity type of the second source/drain pattern SD2 may be the other one of n-type or p-type. In one example embodiment, the first conductivity type may be n-type, and the second conductivity type may be p-type.

The first and second source/drain patterns SD1 and SD2 may be epitaxial patterns formed by a selective epitaxial growth (SEG) process. For example, an upper surface of each of the first and second source/drain patterns SD1 and SD2 may be higher than an upper surface of the third semiconductor pattern SP3. In another example, an upper surface of at least one of the first and second source/drain patterns SD1 and SD2 may be positioned at the same level as or substantially equal to the upper surface of the third semiconductor pattern SP3.

In one example embodiment of the inventive concepts, the first source/drain patterns SD1 may include the same semiconductor element (e.g., Si) as the substrate 100. The second source/drain patterns SD2 may include a semiconductor element (e.g., SiGe) having a lattice constant greater than a lattice constant of the semiconductor element of the substrate 100. Accordingly, the pair of second source/drain patterns SD2 may provide compressive stress to the second channel pattern CH2 therebetween.

Sidewalls of each of the first and second source/drain patterns SD1 and SD2 may have an uneven embossing shape. For example, the sidewalls of each of the first and second source/drain patterns SD1 and SD2 may have a wave-shaped profile. The sidewalls of each of the first and second source/drain patterns SD1 and SD2 may protrude toward first to third inner electrodes PO1, PO2, and PO3 of a gate electrode GE to be described later.

Gate electrodes GE may be provided that extend across the first and second channel patterns CH1 and CH2 in the first direction D1. The gate electrodes GE may be disposed in the second direction D2 by a first pitch. The gate electrodes GE may be disposed in the first direction D1 by a second pitch. A gate spacer GS may be interposed between the gate electrodes GE. The gate electrodes GE may vertically overlap the first and second channel patterns CH1 and CH2, respectively. The gate spacer GS may be interposed between the first active region AR1 and the second active region AR2. The gate spacer GS may be interposed between the gate electrode GE on the first active pattern AP1 and the gate electrode GE on the second active pattern AP2.

The gate electrode GE may include a first inner electrode PO1 between the active pattern AP1 or AP2 and the first semiconductor pattern SP1, a second inner electrode PO2 between the first semiconductor pattern SP1 and the second semiconductor pattern SP2, a third inner electrode PO3 between the second semiconductor pattern SP2 and the third semiconductor pattern SP3, and an outer electrode PO4 on the third semiconductor pattern SP3.

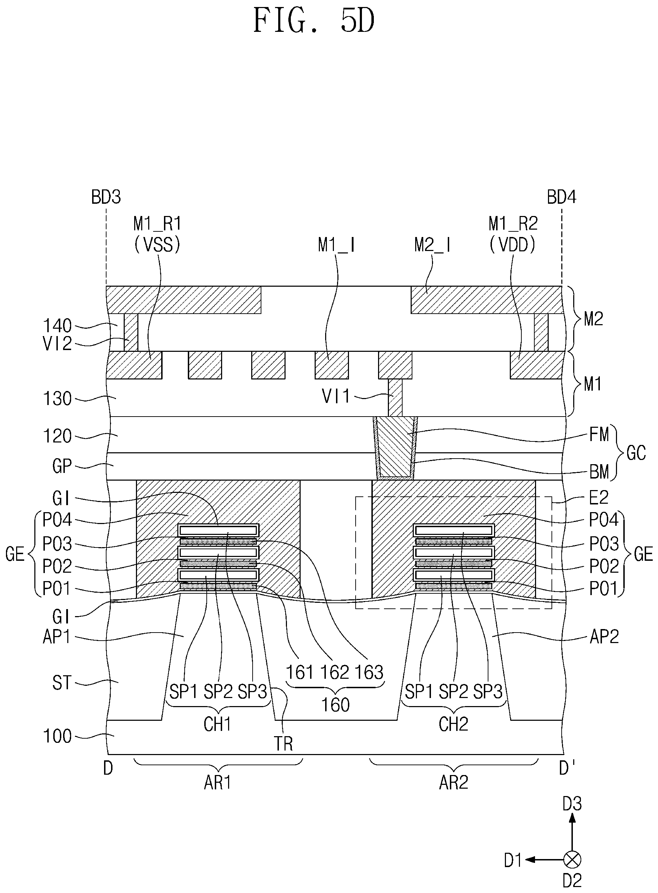

Referring to FIG. 5D, the gate electrode GE may be provided on an upper surface, a bottom surface, and both sidewalls of each of the first to third semiconductor patterns SP1, SP2, and SP3. For example, a transistor according to the present example embodiment may be a three-dimensional field effect transistor (e.g., multibridge-channel metal-oxide-semiconductor field-effect transistor (MBCFET) or Gate-All-Around Field-Effect Transistor (GAAFET)) in which the gate electrode GE three-dimensionally surrounds the first and second channel patterns CH1 and CH2.

Referring again to FIGS. 4 to 5D, a pair of gate spacers GS may be disposed on both sidewalls of the gate electrode GE, respectively. The gate spacers GS may extend along the gate electrode GE in the first direction D1. The gate spacers GS may be disposed between the gate electrodes GE spaced apart in the first direction D1. The gate spacers GS may be in contact with an upper surface of a gate insulating pattern GI and the sidewalls of the gate electrode GE.

An upper surface of the gate spacers GS may be higher than an upper surface of the gate electrode GE. In one example embodiment, the gate spacers GS may include at least one of silicon carbonitride (SiCN), silicon carbonitride (SiCON), or silicon nitride (SiN). In another example embodiment, the gate spacers GS may include a multi-layer layer composed of at least two of silicon carbonitride (SiCN), silicon carbonitride (SiCON), or silicon nitride (SiN).

A gate capping pattern GP may be provided on the gate electrode GE. The gate capping pattern GP may extend in the first direction D1 along the gate electrode GE. The gate capping pattern GP may include a material having etch selectivity with respect to first and second interlayer insulating layers 110 and 120 described below. For example, the gate capping pattern GP may include at least one of silicon oxynitride (SiON), silicon carbonitride (SiCN), silicon carbonitride (SiCON), or silicon nitride (SiN).

The gate insulating pattern GI may be interposed between the gate electrode GE and the first channel pattern CH1 and between the gate electrode GE and the second channel pattern CH2. The gate insulating pattern GI may directly cover the upper surface, the bottom surface, and both sidewalls of each of the first to third semiconductor patterns SP1, SP2, and SP3. The gate insulating pattern GI may cover the upper surface of the device isolation layer ST below the gate electrode GE. The gate insulating pattern GI may include a high-k dielectric material.

The gate electrode GE may include a first metal pattern, and a second metal pattern on the first metal pattern. The first metal pattern may be provided on the gate insulating pattern GI and may be adjacent to the first to third semiconductor patterns SP1, SP2, and SP3. The first metal pattern may include a work function metal that controls a threshold voltage of the transistor. A thickness and composition of the first metal pattern may be adjusted to achieve a desired threshold voltage of a transistor. For example, the first to third inner electrodes PO1, PO2, and PO3 of the gate electrode GE may be formed of a first metal pattern that is a work function metal.

The first metal pattern may include metal nitride. For example, the first metal pattern may include at least one metal selected from the group consisting of titanium (Ti), tantalum (Ta), aluminum (Al), tungsten (W), and molybdenum (Mo) and nitrogen (N). Furthermore, the first metal pattern may further include carbon (C). The first metal pattern may include a plurality of stacked work function metal layers.

The second metal pattern may include metal having a lower resistance than that of the first metal pattern. For example, the second metal pattern may include at least one metal selected from the group consisting of tungsten (W), aluminum (Al), titanium (Ti), and tantalum (Ta). For example, the outer electrode PO4 of the gate electrode GE may include a first metal pattern and a second metal pattern on the first metal pattern.

A thin layer structure 160 may be provided in the gate electrode GE. The thin layer structure 160 may include a first thin layer 161, a second thin layer 162, and a third thin layer 163. The thin layer structure 160 may be provided in the first to third inner electrodes PO1, PO2, and PO3 of the gate electrode GE. The thin layer structure 160 may be spaced apart from the gate insulating pattern GI. The thin layer structure 160 may be surrounded by the gate electrode GE. The thin layer structure 160 may be spaced apart from the first channel pattern CH1 and the second channel pattern CH2.

The thin layer structure 160 may provide a tensile strain between the gate electrodes GE. In another case, the thin layer structure 160 may provide compressive strain between the gate electrodes GE. The thin layer structure 160 may include a material having one of tensile strain or compressive strain. For example, when the first to third semiconductor patterns SP1, SP2, and SP3 include a two-dimensional material doped with an N-type conductive material, the thin layer structure 160 may include nitride. In this case, the thin layer structure 160 may provide tensile strain to the first to third semiconductor patterns SP1, SP2, and SP3.

For example, when the first to third semiconductor patterns SP1, SP2, and SP3 include a two-dimensional material doped with a P-type conductive material, the thin layer structure 160 may include oxide. In this case, the thin layer structure 160 may provide compressive strain to the first to third semiconductor patterns SP1, SP2, and SP3.

The first thin layer 161 may be provided in the first inner electrode PO1. The second thin layer 162 may be provided in the second inner electrode PO2. The third thin layer 163 may be provided in the third inner electrode PO3.

A first interlayer insulating layer 110 may be provided on the substrate 100. The first interlayer insulating layer 110 may cover the gate spacers GS and the first and second source/drain patterns SD1 and SD2. An upper surface of the first interlayer insulating layer 110 may be substantially coplanar with an upper surface of the gate capping pattern GP and an upper surface of the gate spacer GS. A second interlayer insulating layer 120 covering the gate capping pattern GP may be disposed on the first interlayer insulating layer 110. A third interlayer insulating layer 130 may be provided on the second interlayer insulating layer 120. A fourth interlayer insulating layer 140 may be provided on the third interlayer insulating layer 130. For example, the first to fourth interlayer insulating layers 110, 120, 130, and 140 may include silicon oxide.

The single height cell SHC may have a first boundary BD1 and a second boundary BD2 facing each other in a second direction D2. The first and second boundaries BD1 and BD2 may extend in the first direction D1. The single height cell SHC may have a third boundary BD3 and a fourth boundary BD4 facing each other in the first direction D1. The third and fourth boundaries BD3 and BD4 may extend in the second direction D2.

A pair of separation structures DB facing each other in the second direction D2 may be provided on both sides of the single height cell SHC. For example, a pair of separation structures DB may be provided on the first and second boundaries BD1 and BD2 of the single height cell SHC, respectively. The separation structure DB may extend parallel to the gate electrodes GE in the first direction D1. A pitch between the separation structure DB and the gate electrode GE adjacent thereto may be equal to the first pitch.

The separation structure DB may penetrate the gate capping pattern GP and the gate electrode GE and may extend into the first and second active patterns AP1 and AP2. The separation structure DB may penetrate upper portions of the first and second active patterns AP1 and AP2, respectively. The separation structure DB may electrically separate an active region of a single height cell SHC from an active region of an adjacent cell.

Active contacts AC may penetrate the first and second interlayer insulating layers 110 and 120 and may be electrically connected to the first and second source/drain patterns SD1 and SD2, respectively. A pair of active contacts AC may be provided on the two sides of the gate electrode GE, respectively. When viewed in a plan view, the active contact AC may have a bar shape extending in the first direction D1.

The active contact AC may be a self-aligned contact. For example, the active contact AC may be formed in a self-aligned manner using the gate capping pattern GP and the gate spacer GS. For example, the active contact AC may cover at least a portion of a sidewall of the gate spacer GS. Although not shown, the active contact AC may cover a portion of an upper surface of the gate capping pattern GP.

A metal-semiconductor compound layer SC, for example, a silicide layer, may be interposed between the active contact AC and the first source/drain pattern SD1 and between the active contact AC and the second source/drain pattern SD2, respectively. The active contact AC may be electrically connected to the source/drain pattern SD1 or SD2 through the metal-semiconductor compound layer SC. For example, the metal-semiconductor compound layer SC may include at least one of titanium-silicide, tantalum-silicide, tungsten-silicide, nickel-silicide, or cobalt-silicide.

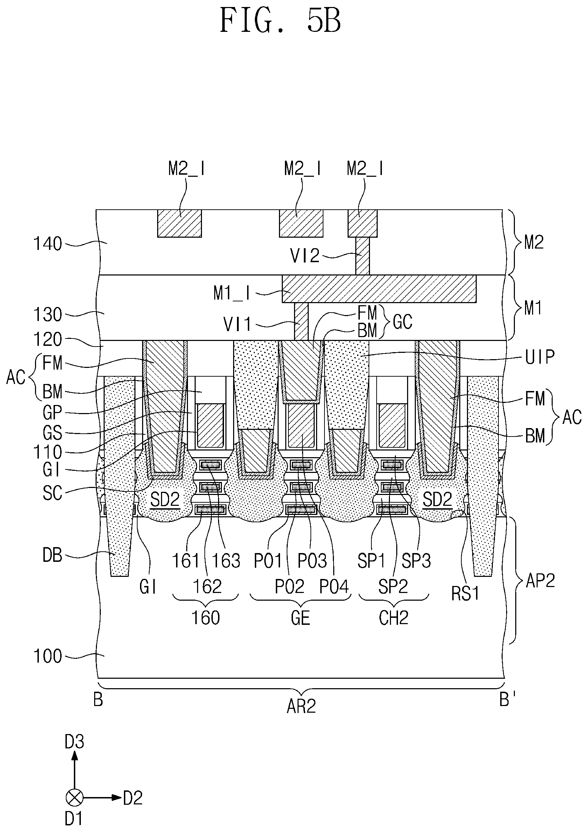

Gate contacts GC may penetrate the second interlayer insulating layer 120 and the gate capping pattern GP and may be electrically connected to the gate electrodes GE respectively. When viewed in a plan view, the gate contacts GC may overlap the first active region AR1 and the second active region AR2, respectively. As an example, the gate contact GC may be provided on the second active pattern AP2 (refer to FIG. 5B).

In one example embodiment of the inventive concepts, referring to FIG. 5B, an upper portion of the active contact AC adjacent to the gate contact GC may be filled with an upper insulating pattern UIP. A bottom surface of the upper insulating pattern UIP may be lower than a bottom surface of the gate contact GC. For example, a top surface of the active contact AC adjacent to the gate contact GC may be lowered lower than a bottom surface of the gate contact GC by the upper insulating pattern UIP. Thus, problem of the gate contact GC coming into contact with the adjacent active contact AC and causing a short circuit may be reduced or prevented.

Each of the active contact AC and the gate contact GC may include a conductive pattern FM and a barrier pattern BM surrounding the conductive pattern FM. For example, the conductive pattern FM may include at least one metal selected from aluminum, copper, tungsten, molybdenum, or cobalt. The barrier pattern BM may cover sidewalls and a bottom surface of the conductive pattern FM. The barrier pattern BM may include a metal layer/metal nitride layer. The metal layer may include at least one of titanium, tantalum, tungsten, nickel, cobalt, or platinum. The metal nitride layer may include at least one of a titanium nitride layer (TiN), a tantalum nitride layer (TaN), a tungsten nitride layer (WN), a nickel nitride layer (NiN), a cobalt nitride layer (CoN), or a platinum nitride layer (PtN).

A first metal layer M1 may be provided in the third interlayer insulating layer 130. For example, the first metal layer M1 may include a first power line M1_R1, a second power line M1_R2, and first wiring lines M1_I. The lines M1_R1, M1_R2, and M1_I of the first metal layer M1 may extend parallel to each other in the second direction D2.

For example, the first and second power lines M1_R1 and M1_R2 may be provided on the third and fourth boundaries BD3 and BD4 of the single height cell SHC, respectively. The first power line M1_R1 may extend in the second direction D2 along the third boundary BD3. The second power line M1_R2 may extend in the second direction D2 along the fourth boundary BD4.

The first wiring lines M1_I of the first metal layer M1 may be disposed between the first and second power lines M1_R1 and M1_R2. The first wiring lines M1_I of the first metal layer M1 may be disposed (e.g., arranged) in the first direction D1 by a second pitch. The second pitch may be less than the first pitch. A line width of each of the first wiring lines M1_I may be less than a line width of each of the first and second power lines M1_R1 and M1_R2.

The first metal layer M1 may further include first vias VI1. The first vias VI1 may be provided below the lines M1_R1, M1_R2, and M1_I of the first metal layer M1, respectively. The active contact AC and the lines of the first metal layer M1 may be electrically connected to each other through the first via VI1. The gate contact GC and the lines of the first metal layer M1 may be electrically connected to each other through the first via VI1.

The line of the first metal layer M1 and the first via VI1 thereunder may be formed through separate processes. In some example embodiments, each of the line of the first metal layer M1 and the first via VI1 may be formed by a single damascene process. The semiconductor device according to the present example embodiment may be formed by using a process of less than 20 nm.

A second metal layer M2 may be provided in the fourth interlayer insulating layer 140. The second metal layer M2 may include a plurality of second wiring lines M2_I. Each of the second wiring lines M2 _I of the second metal layer M2 may have a line shape or a bar shape extending in the first direction D1. For example, the second wiring lines M2_I may extend in parallel to each other in the first direction D1.

The second metal layer M2 may further include second vias VI2 provided below the second wiring lines M2_I. The line of the first metal layer M1 and the line of the second metal layer M2 may be electrically connected to each other through the second via VI2. For example, the line of the second metal layer M2 and the second via VI2 thereunder may be formed together by a dual damascene process.

The line of the first metal layer M1 and the line of the second metal layer M2 may include the same or different conductive materials. For example, the line of the first metal layer M1 and the line of the second metal layer M2 may include at least one metal material selected from aluminum, copper, tungsten, molybdenum, ruthenium, and cobalt. Although not shown, metal layers (e.g., M3, M4, M5...) stacked on the fourth interlayer insulating layer 140 may be additionally provided. Each of the stacked metal layers may include lines for routing between cells.

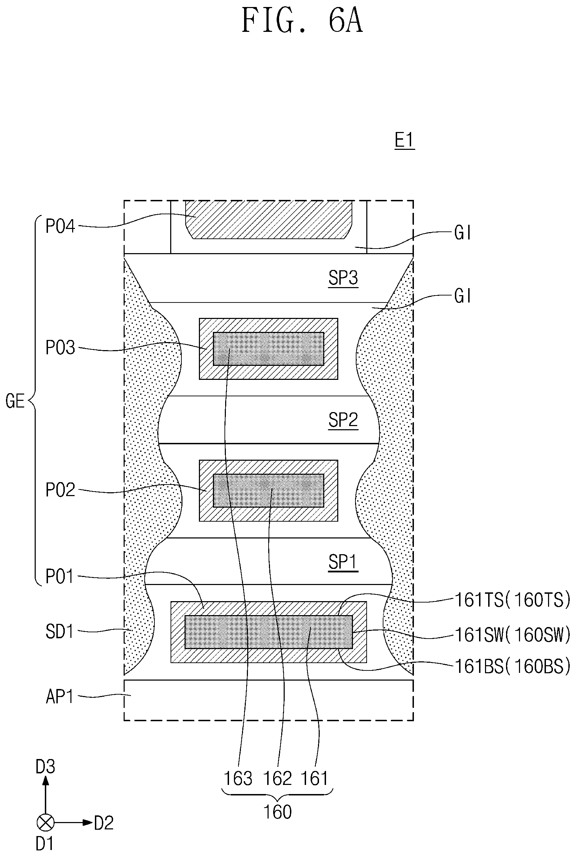

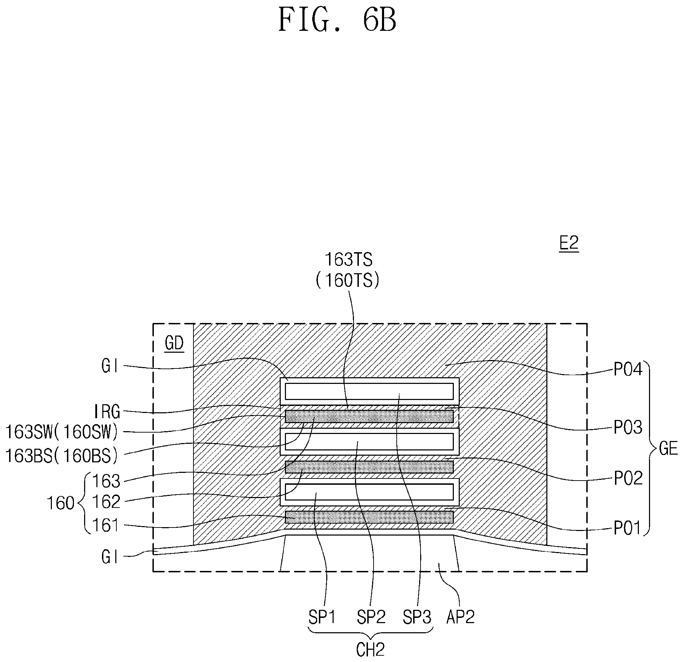

FIG. 6A is an enlarged view corresponding to portion 'E1' of FIG. 5A. FIG. 6B is an enlarged view corresponding to portion 'E2' of FIG. 5D. Hereinafter, with reference to FIGS. 6A and 6B, the thin layer structure 160 according to some example embodiments of the inventive concepts will be described in more detail. For simplicity of explanation, any description overlapping with the above will be omitted.

Referring to FIGS. 6A and 6B, the thin layer structure 160, the first to third semiconductor patterns SP1, SP2, and SP3, and the gate electrode GE are illustrated in more detail.

The first thin layer 161 may be surrounded by the first inner electrode PO1. The second thin layer 162 may be surrounded by the second inner electrode PO2. The third thin layer 163 may be surrounded by the third inner electrode PO3. Each of the first to third inner electrodes PO1, PO2, and PO3 may be surrounded by the gate insulating pattern GI.

The first thin layer 161 may be disposed in the first inner electrode PO1. The second thin layer 162 may be disposed in the second inner electrode PO2. The third thin layer 163 may be disposed in the third inner electrode PO3.

The thin layer structure 160 may include an upper surface 160TS, a sidewall 160SW, and a lower surface 160BS of the thin layer structure. The upper surface 160TS, the sidewall 160SW, and the lower surface 160BS of the thin layer structure may be in contact with the gate electrode GE. The upper surface 160TS, the sidewall 160SW, and the lower surface 160BS of the thin layer structure may be spaced apart from the gate insulating pattern GI. The upper surface 160TS, the sidewall 160SW, and the lower surface 160BS of the thin layer structure may be spaced apart from the semiconductor patterns SP1, SP2, and SP3. The upper surface 160TS, the sidewall 160SW, and the lower surface 160BS of the thin layer structure may be spaced apart from the source/drain pattern SD1.

A width of the thin layer structure 160 in the second direction D2 may be less than a width of the gate electrode GE in the second direction D2. A height of the thin layer structure in the third direction D3 may be less than a height of the gate electrode GE in the third direction D3.

Although the width of the first thin layer 161 in the second direction D2 is shown to be greater than widths of the second thin layer 162 and the third thin layer 163 in the second direction D2, widths of the first to third thin layers 161, 162, and 163 may be the same as each other or may be different from each other.

Inner regions IRG may be defined between the first to third semiconductor patterns SP1, SP2, and SP3. The gate electrode GE may be provided in the inner regions IRG.

The thin layer structure 160 may be provided in the inner regions IRG. The gate electrode GE may surround the thin layer structure 160 in the inner regions IRG.

According to some example embodiments of the inventive concepts, the thin layer structure 160 may be provided in the gate electrode GE. The thin layer structure 160 may provide tensile strain or compressive strain in the gate electrode GE. An ion mobility of the channel pattern CH1 and CH2 and the gate electrode GE including the two-dimensional material may be improved by the thin layer structure 160. Electrical characteristics and/or reliability of the semiconductor device may be improved.

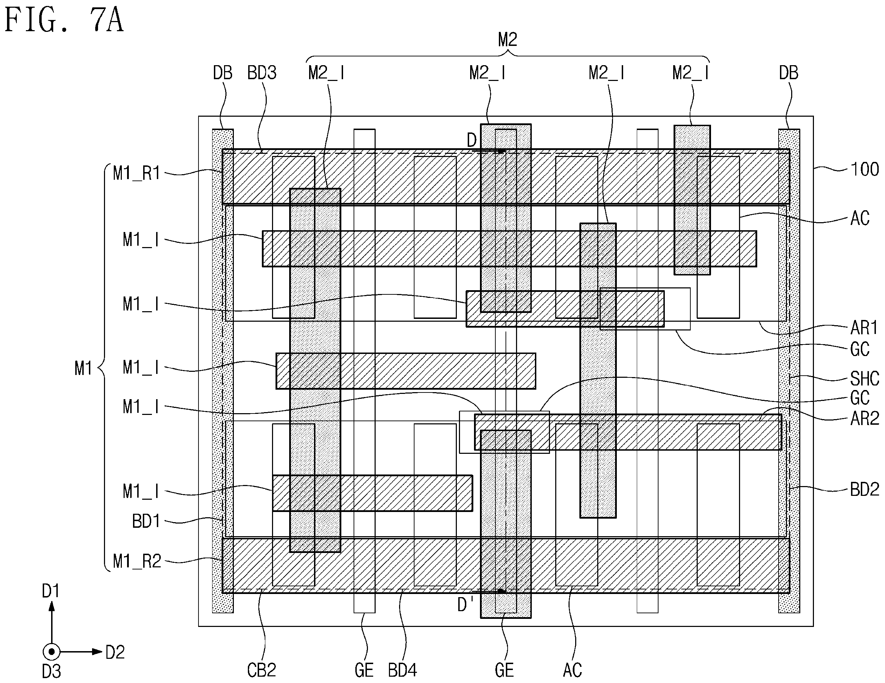

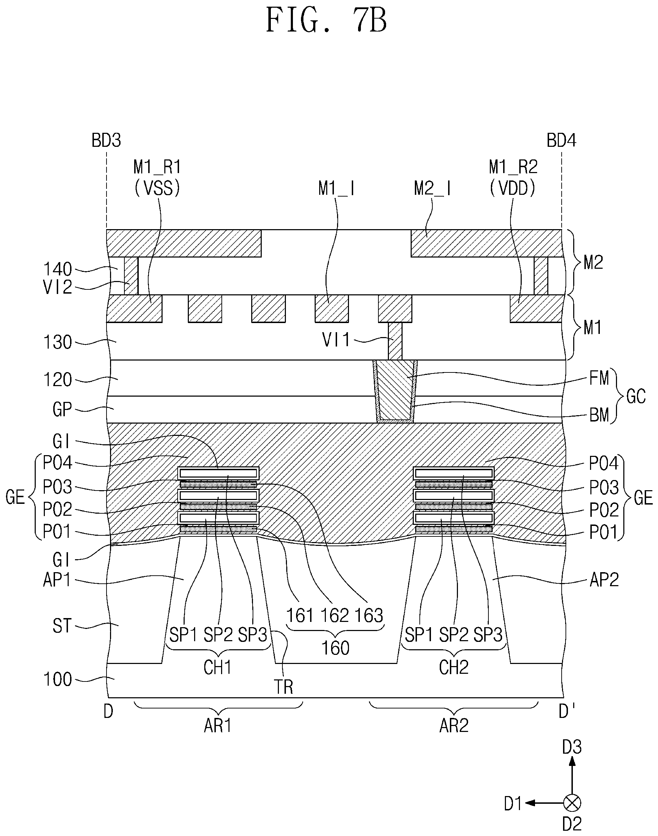

FIG. 7A is a plan view for explaining a semiconductor device according to an example embodiment of the inventive concepts. FIG. 7B is a cross-sectional view along line D-D' of FIG. 7A. For simplicity of explanation, descriptions that overlap the above are omitted.

Referring to FIGS. 7A and 7B, the gate spacer GS may not be interposed between the first active region AR1 and the second active region AR2. The gate electrode GE may extend in the first direction D1. One gate electrode GE (instead of two gate electrodes separate apart from each other) may extend over the first active region AR1 and the second active region AR2. One gate electrode GE (instead of two gate electrodes separate apart from each other) may extend over the first active pattern AP1 and the second active pattern AP2.

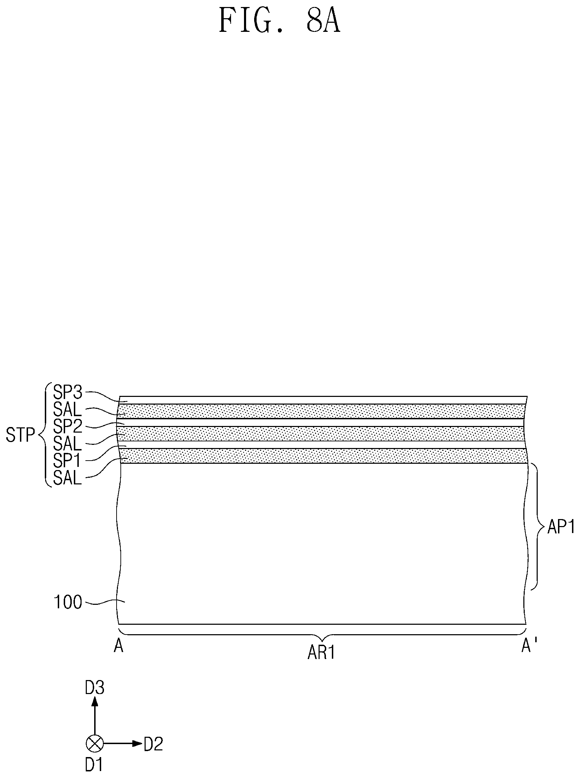

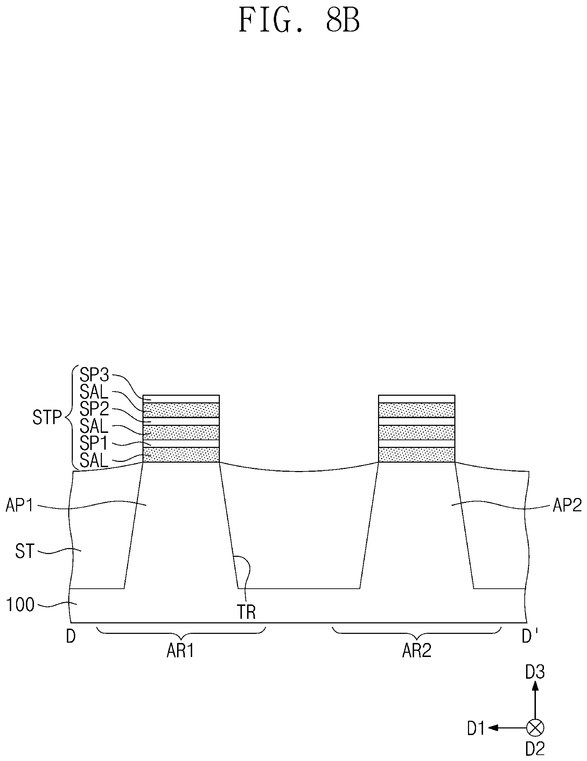

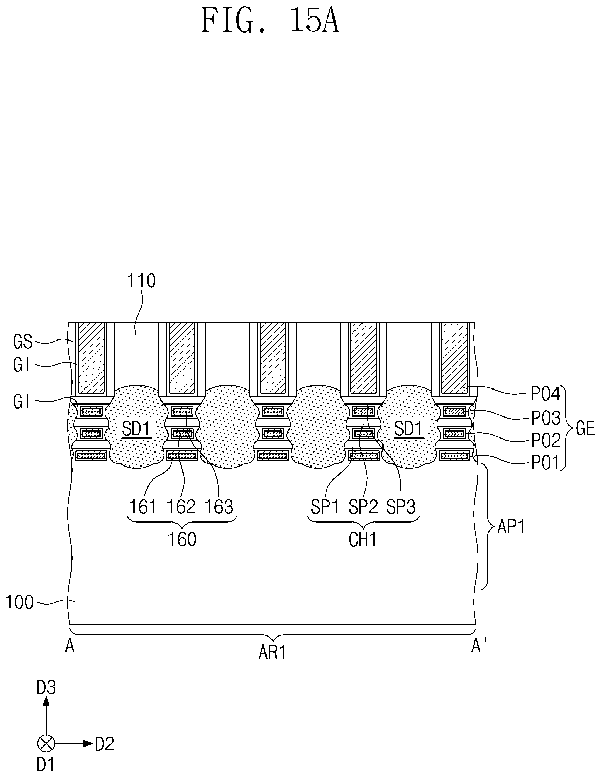

FIGS. 8A to 12B are cross-sectional views illustrating a method of manufacturing a semiconductor device according to an example embodiment of the inventive concepts. Specifically, FIGS. 8A, 9A, 10A, 11A, 12A, 13A, 14A, and 15A are cross-sectional views corresponding to line A-A' of FIG. 4. FIGS. 8B, 9B, 10B, 11B, 12B, 13B, 14B, and 15B are cross-sectional views corresponding to line D-D' of FIG. 4. Hereinafter, with reference to FIGS. 8A to 15B, a method of manufacturing a semiconductor device according to an example embodiment of the inventive concepts will be described. For simplicity of explanation, descriptions that overlap the above will be omitted.

Referring to FIGS. 8A and 8B, a substrate 100 including first and second active regions AR1 and AR2 may be provided. An active layer (not shown) and sacrificial layers SAL alternately stacked on the substrate 100 may be formed. The active layer (not shown) may include a two-dimensional material, and the sacrificial layers SAL may include one of silicon (Si), germanium (Ge), or silicon-germanium (SiGe). The sacrificial layer SAL may include a material that may have an etching selectivity with respect to the active layer (not shown).

Mask patterns may be formed on the first and second active regions AR1 and AR2 of the substrate 100, respectively. The mask pattern may have a line shape or a bar shape extending in a second direction D2.

A patterning process may be performed using the above mask patterns as an etching mask, to form a trench TR defining a first active pattern AP1 and a second active pattern AP2. The first active pattern AP1 may be formed on a first active region AR1. The second active pattern AP2 may be formed on a second active region AR2.

A stacked pattern STP may be formed on each of the first and second active patterns AP1 and AP2. The stacked pattern STP may include semiconductor patterns SP1, SP2, and SP3 and sacrificial layers SAL that are alternately stacked. The stacked pattern STP may be formed together with the first and second active patterns AP1 and AP2 during the patterning process. An active layer (not shown) may be patterned, and the semiconductor patterns SP1, SP2, and SP3 spaced apart from each other in a first direction D1 may be formed.

A device isolation layer ST filling the trench TR may be formed. For example, an insulating layer covering the first and second active patterns AP1 and AP2 and the stacked patterns STP may be formed on the entire surface of the substrate 100. The insulating layer may be recessed until the stacked patterns STP are exposed, thereby forming the device isolation layer ST.

The device isolation layer ST may include an insulating material, such as silicon oxide. The stacked patterns STP may be exposed over the device isolation layer ST. For example, the stacked patterns STP may protrude vertically over the device isolation layer ST.

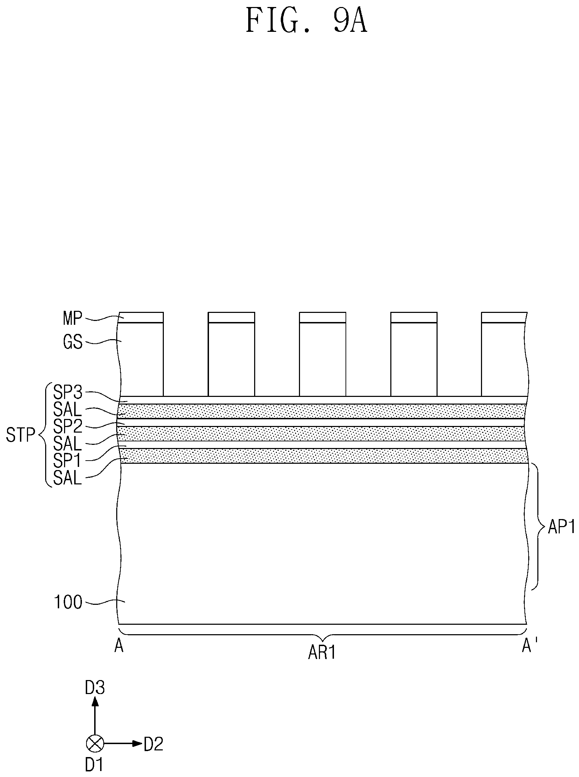

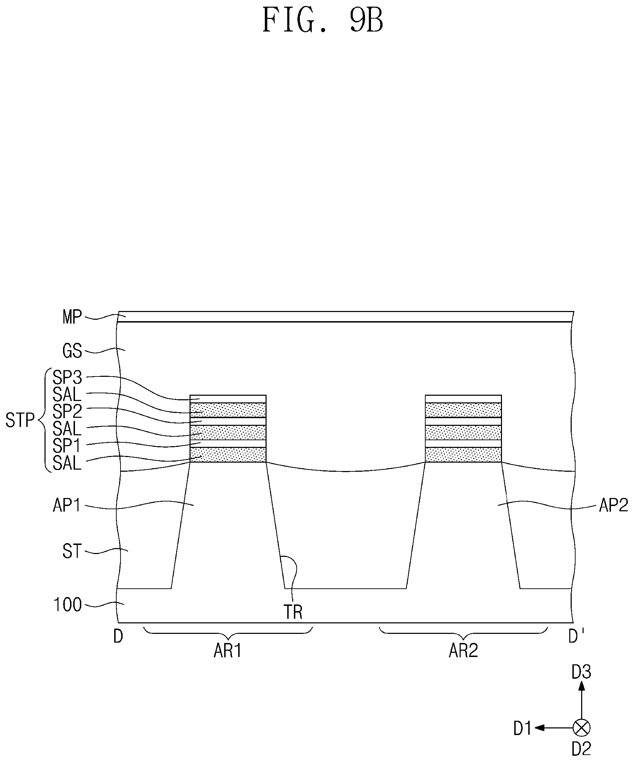

Referring to FIGS. 9A and 9B, a gate spacer GS may be formed on the stacked patterns STP on the substrate 100. The gate spacer GS may be formed to cover the stacked pattern STP and the device isolation layer ST. The gate spacer GS may be formed in a line shape or a bar shape extending in the first direction D1. The gate spacers GS may be disposed (e.g., arranged) in the second direction D2 by the first pitch.

For example, forming the gate spacer GS may include forming a gate spacer layer on the entire surface of the substrate 100, forming hard mask patterns MP on the gate spacer layer, and patterning the gate spacer layer using the hard mask patterns MP as an etching mask.

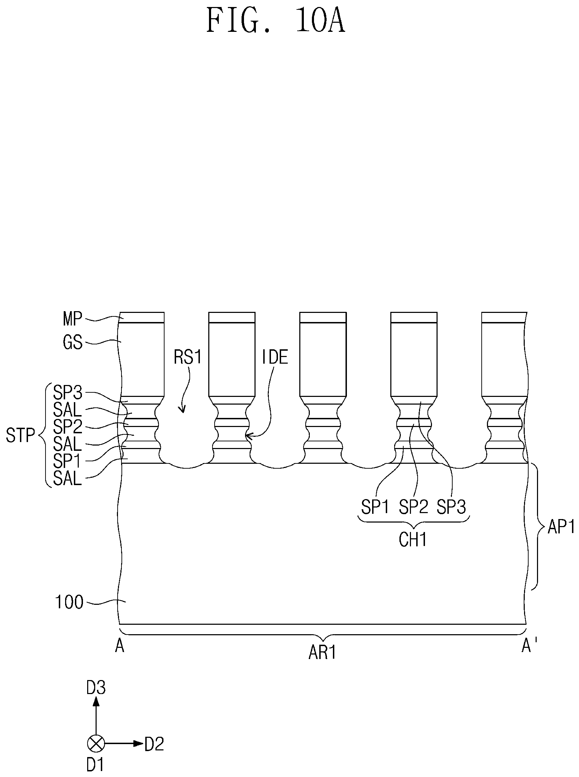

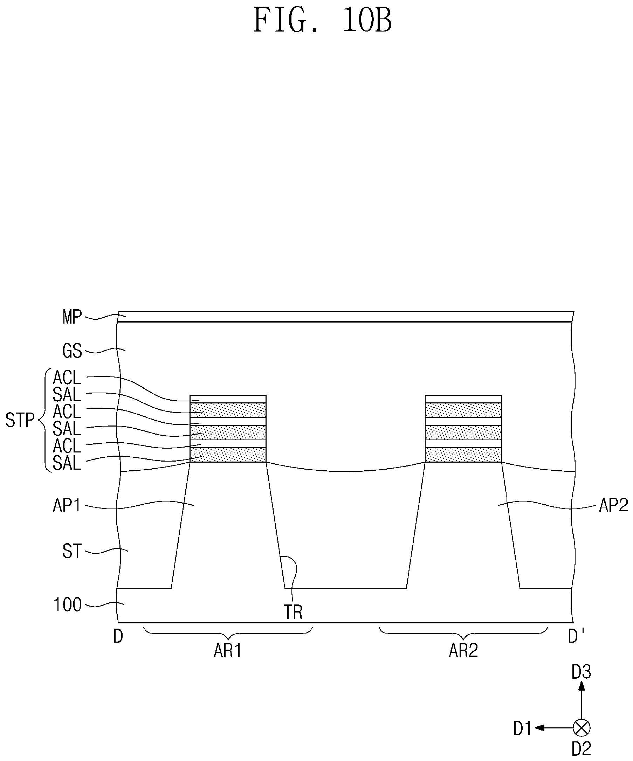

Referring to FIGS. 10A and 10B, first recesses RS1 may be formed in the stacked pattern STP on the first active pattern AP1. Second recesses may be formed in the stacked pattern STP on the second active pattern AP2.

During the forming of the first recesses RS1 and the second recesses, the device isolation layer ST on both sides of each of the first and second active patterns AP1 and AP2 may be further recessed.

For example, the stacked pattern STP on the first active pattern AP1 may be etched using the hard mask patterns MP and the gate spacers GS as an etching mask to form the first recesses RS1.

In one example embodiment of the inventive concepts, forming the first recess RS1 may include additionally performing a selective etching process on the exposed sacrificial layers SAL. By the selective etching process, each of the sacrificial layers SAL may be indented, thereby forming an indent region IDE. Thus, the first recess RS1 may have a wavy inner wall. The second recesses in the stacked pattern STP on the second active pattern AP2 may be formed in the same manner as forming the first recesses RS1.

The first to third semiconductor patterns SP1, SP2, and SP3 sequentially stacked between the adjacent first recesses RS1 may be exposed, respectively. The first to third semiconductor patterns SP1, SP2, and SP3 between the adjacent first recesses RS1 may form a first channel pattern CH1. The first to third semiconductor patterns SP1, SP2, and SP3 between the adjacent second recesses may form a second channel pattern.

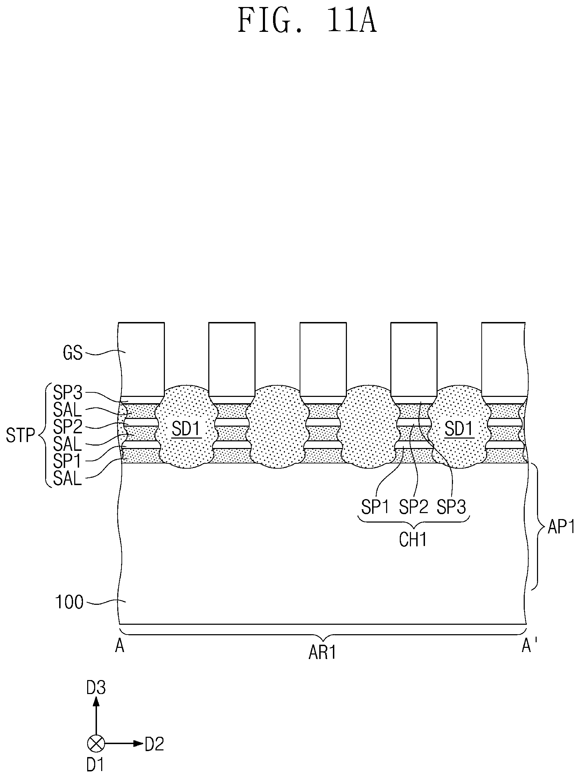

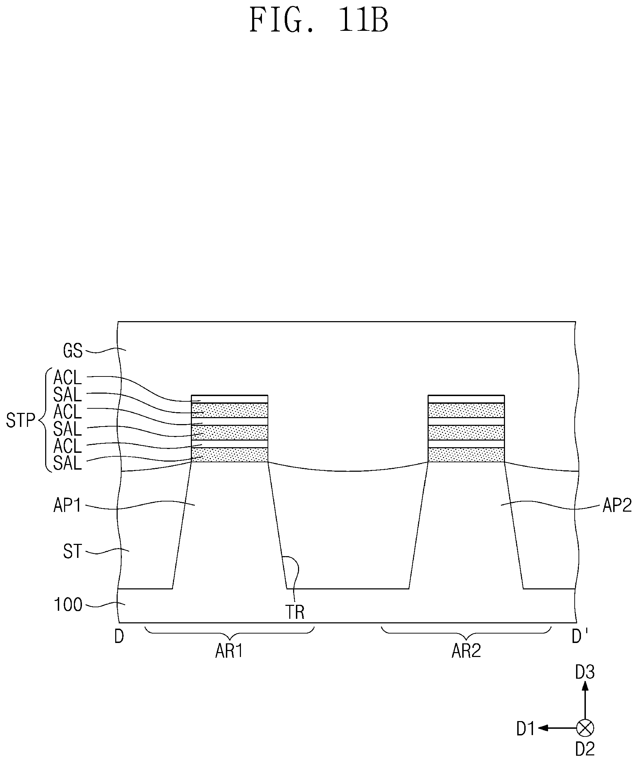

Referring to FIGS. 11A and 11B, first source/drain patterns SD1 may be respectively formed in the first recesses RS1. For example, an SEG process may be performed using an inner wall of the first recess RS1 as a seed layer, and an epitaxial layer filling the first recess RS1 may be formed. The epitaxial layer may be grown using the first to third semiconductor patterns SP1, SP2, and SP3 exposed by the first recess RS1 and the substrate 100 as a seed. As an example, the SEG process may include a chemical vapor deposition (CVD) process or a molecular beam epitaxy (MBE) process.

In one example embodiment of the inventive concepts, the first source/drain pattern SD1 may include the same semiconductor element (e.g., Si) as the substrate 100. While the first source/drain pattern SD1 is formed, the first source/drain pattern SD1 may be implanted with impurities in-situ. As another example, after the first source/drain pattern SD1 is formed, the first source/drain pattern SD1 may be implanted with impurities. Second source/drain patterns may also be formed in the same manner. The hard mask pattern MP may be removed.

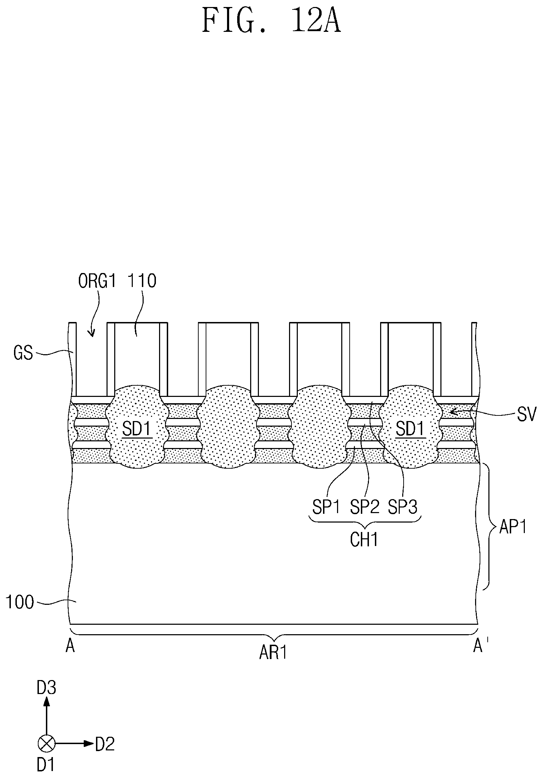

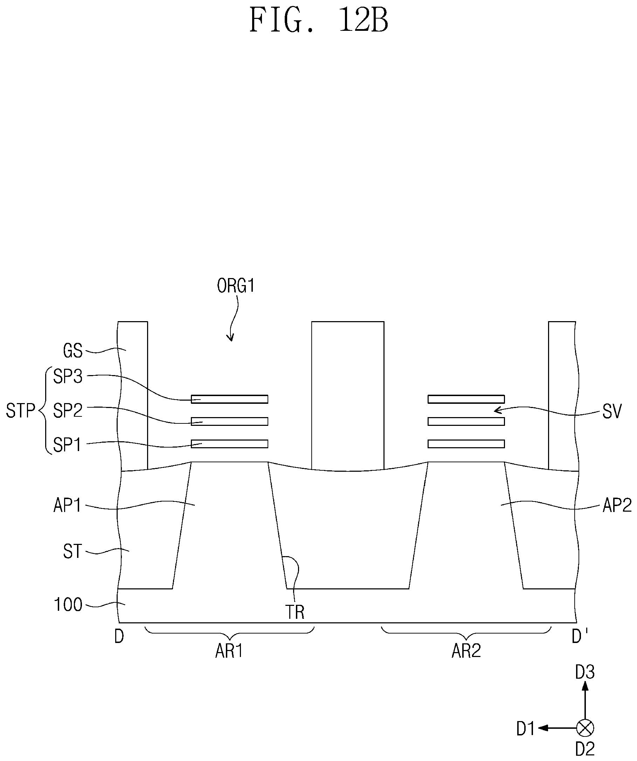

Referring to FIGS. 12A and 12B, a first interlayer insulating layer 110 covering the first source/drain patterns SD1 and the second source/drain pattern and the gate spacer GS may be formed. As an example, the first interlayer insulating layer 110 may include silicon oxide.

The first interlayer insulating layer 110 may be planarized until an upper surface of the gate spacer GS are exposed. The planarization of the first interlayer insulating layer 110 may be performed using an etch back or chemical mechanical polishing (CMP) process. The hard mask pattern MP may be removed during the planarization process. The hard mask pattern MP may be removed after the first interlayer insulating layer 110 is formed. Thus, an upper surface of the first interlayer insulating layer 110 may be coplanar with an upper surface of the gate spacer GS.

The gate spacer GS may be selectively removed. The gate spacer GS may be removed, and the first outer region ORG1 exposing the first channel patterns CH1 and the second channel patterns may be formed. Removing the gate spacer GS may include wet etching using an etchant that selectively etches the gate spacer GS.

The sacrificial layers SAL exposed through the first outer region ORG1 may be selectively removed to form inner regions SV. For example, an etching process that selectively etches the sacrificial layers SAL may be etched, and only the sacrificial layers SAL may be removed while the first to third semiconductor patterns SP1, SP2, and SP3 remain intact.

During the etching process, the sacrificial layers SAL on the first and second active regions AR1 and AR2 may be removed. The etching process may be wet etching.

As the sacrificial layers SAL are selectively removed, only the first to third semiconductor patterns SP1, SP2, and SP3 stacked on each of the first and second active patterns AP1 and AP2 may remain. The inner regions SV may be formed through the regions where the sacrificial layers SAL are removed, respectively.

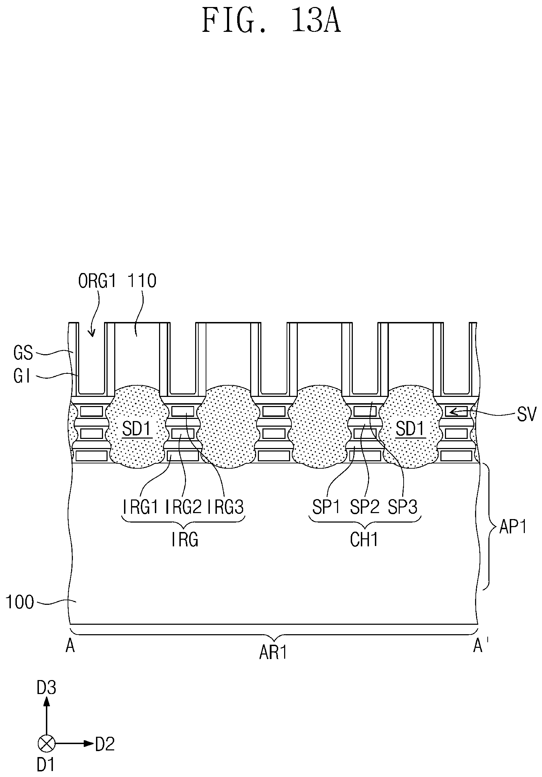

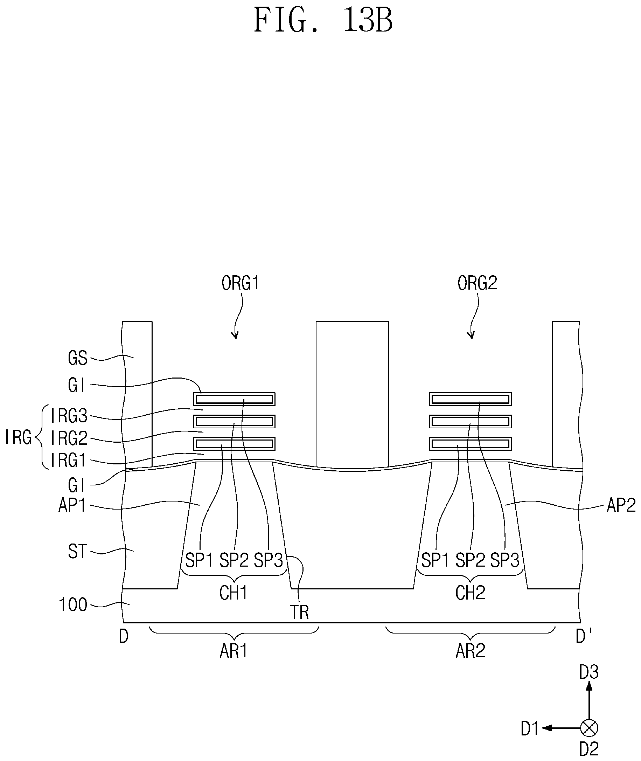

Referring to FIGS. 13A and 13B, a gate insulating pattern GI may be formed on the exposed first to third semiconductor patterns SP1, SP2, and SP3. The gate insulating pattern GI may be formed to surround each of the first to third semiconductor patterns SP1, SP2, and SP3. The gate insulating pattern GI may be formed in each of the inner regions SV. The gate insulating pattern GI may be formed in the first outer region ORG1. A second outer region ORG2 may be formed to expose the gate insulating pattern GI and the gate spacer GS.

One side of the gate insulating pattern GI may be exposed through the second outer region ORG2. A sidewall of the gate spacer GS may be exposed through the second outer region ORG2.

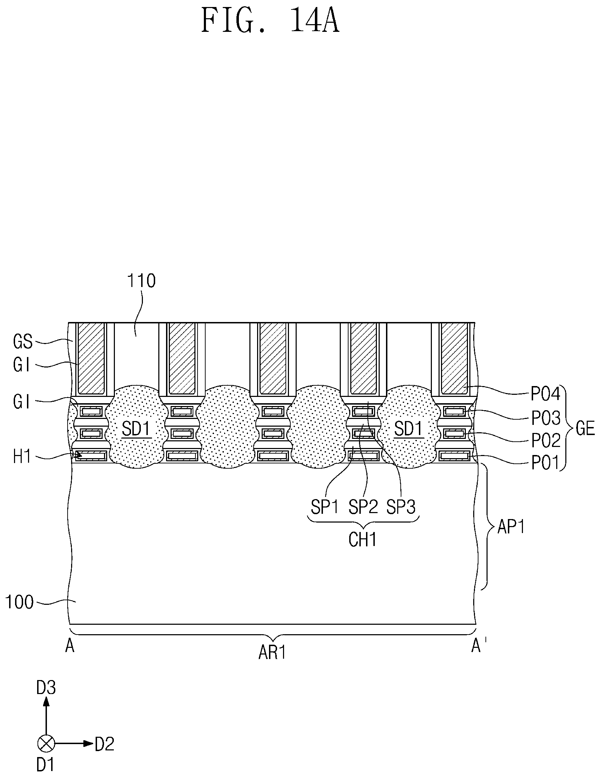

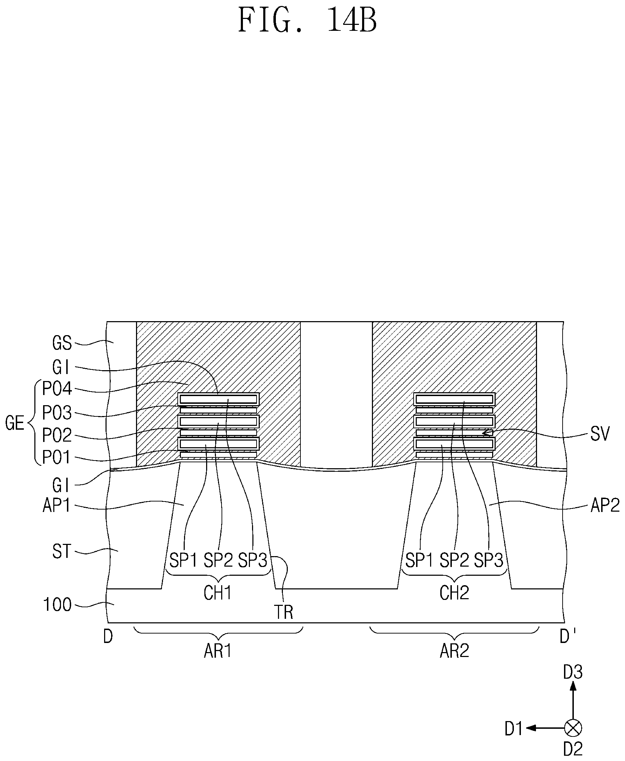

Referring to FIGS. 14A and 14B, a gate electrode GE may be formed on a gate insulating pattern GI. The gate electrode GE may include first to third inner electrodes PO1, PO2, and PO3 formed respectively in the inner regions SV and an outer electrode PO4 formed in the outer region (e.g., in each of the first outer ORG1 and the second outer ORG2). The gate electrode GE may be formed to fill a portion of the inner regions SV. The gate electrode GE may be formed to conformally cover the gate insulating pattern GI. A portion of the inner regions SV may remain unfilled. The remainder of the inner regions SV may be filled with the gate electrode GE. The gate electrode GE may be filled between spaced apart gate spacers GS. The first to third inner electrodes PO1, PO2, and PO3 may be formed to not fill a portion of the inner regions SV.

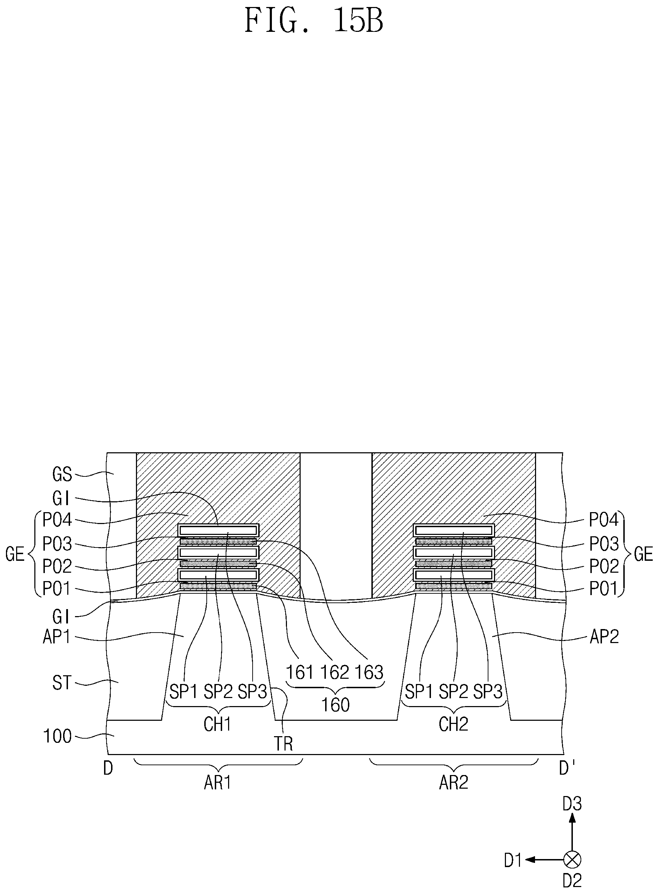

Referring to FIGS. 15A and 15B, unfilled inner regions SV may be filled with a thin layer structure 160. A first thin layer 161 may be filled in the first inner electrode PO1. A second thin layer 162 may be filled in the second inner electrode PO2. A third thin layer 163 may be filled in the third inner electrode PO3. The thin layer structure 160 may be formed.

Referring again to FIGS. 5A to 5D, the gate electrode GE may be recessed to reduce a height thereof. A gate capping pattern GP may be formed on the recessed gate electrode GE. A second interlayer insulating layer 120 may be formed on the first interlayer insulating layer 110. The second interlayer insulating layer 120 may include silicon oxide. Active contacts AC may penetrate the second interlayer insulating layer 120 and the first interlayer insulating layer 110 and may be electrically connected to the first and second source/drain patterns SD1 and SD2. Gate contacts GC may penetrate the second interlayer insulating layer 120 and the gate capping pattern GP and may be electrically connected to the gate electrode GE.

Forming each of the active contacts AC and the gate contact GC may include forming a barrier pattern BM and forming a conductive pattern FM on the barrier pattern BM. The barrier pattern BM may be formed conformally and may include a metal layer or metal nitride. The conductive pattern FM may include low-resistance metal.

Separation structures DB may be formed at a first boundary BD1 and a second boundary BD2 of the single height cell SHC, respectively. The separation structure DB may penetrate the gate capping pattern GP and the gate electrode GE and may extend into the active pattern AP1 or AP2. The separation structure DB may include an insulating material such as silicon oxide or silicon nitride.

A third interlayer insulating layer 130 may be formed on the active contacts AC and the gate contacts GC. A first metal layer M1 may be formed in the third interlayer insulating layer 130. A fourth interlayer insulating layer 140 may be formed on the third interlayer insulating layer 130. A second metal layer M2 may be formed in the fourth interlayer insulating layer 140. A semiconductor device may be finally formed.

According to the inventive concepts, the thin layer structure may be disposed in the gate electrode. The thin layer structure may be disposed spaced apart from the gate insulating pattern and the semiconductor patterns. The thin layer structure may include the material having tensile or compressive strain. The ion mobility of the semiconductor device may be improved through the thin layer structure. The electrical characteristics and/or reliability of the semiconductor device may be improved.

While some example embodiments are described above, a person skilled in the art may understand that many modifications and variations are made without departing from the spirit and scope of the inventive concepts defined in the following claims. Accordingly, the above-described example embodiments of the inventive concepts should be considered in all respects as illustrative and not restrictive, with the spirit and scope of the inventive concepts being indicated by the appended claims.

## Claims

1. A semiconductor device comprising:
a substrate including an active pattern;
first and second semiconductor patterns vertically spaced apart from each other on the active pattern;
a gate electrode between the first and second semiconductor patterns;
a gate insulating pattern surrounding the gate electrode; and
a thin layer structure in the gate electrode,
wherein the thin layer structure is surrounded by the gate electrode, and
wherein the thin layer structure is spaced apart from the gate insulating pattern.

2. The semiconductor device of claim 1, further comprising:
a source/drain pattern connected to each of the first and second semiconductor patterns,
wherein the source/drain pattern is spaced apart from the thin layer structure.

3. The semiconductor device of claim 1, wherein the thin layer structure is spaced apart from the first and second semiconductor patterns.

4. The semiconductor device of claim 1, wherein the thin layer structure includes one of oxide or nitride.

5. The semiconductor device of claim 1, wherein
the first and second semiconductor patterns include a two-dimensional material, and
the two-dimensional material includes at least one of graphene, a transition metal chalcogenide, black phosphorus, or a two-dimensional oxide.

6. The semiconductor device of claim 1, wherein
the first and second semiconductor patterns include a two-dimensional material doped with an N type, and
the thin layer structure includes nitride.

7. The semiconductor device of claim 1, wherein
the first and second semiconductor patterns include a two-dimensional material doped with a P type, and
the thin layer structure includes oxide.

8. The semiconductor device of claim 1, wherein the gate insulating pattern includes a high-k dielectric material.

9. The semiconductor device of claim 1, wherein
the thin layer structure includes an upper surface, sidewalls, and a lower surface thereof,
the gate electrode is between the upper surface of the thin layer structure and the gate insulating pattern, and
wherein the gate electrode is between the lower surface of the thin layer structure and the gate insulating pattern.

10. The semiconductor device of claim 1, wherein
the active pattern includes a first active pattern and a second active pattern spaced apart from the first active pattern,
the gate electrode includes a first gate electrode and a second gate electrode,
the semiconductor device further includes a gate spacer interposed between the first gate electrode on the first active pattern and the second gate electrode on the second active pattern, and
the thin layer structure is spaced apart from the gate spacer.

11. A semiconductor device comprising:
a substrate including an active pattern;
first and second semiconductor patterns vertically spaced apart from each other on the active pattern;
a gate electrode between the first and second semiconductor patterns, the gate electrode including a plurality of gate electrodes;
a gate spacer between the plurality of gate electrodes;
a gate insulating pattern surrounding the gate electrode; and
a thin layer structure in the gate electrode,
wherein the thin layer structure is spaced apart from the gate spacer and the gate insulating pattern.

12. The semiconductor device of claim 11, wherein
the thin layer structure includes an upper surface, a sidewall, and a lower surface thereof,
the gate electrode is between the upper surface of the thin layer structure and the gate insulating pattern,
the gate electrode is between the lower surface of the thin layer structure and the gate insulating pattern, and
the gate electrode is between the sidewall of the thin layer structure and the gate spacer.

13. The semiconductor device of claim 11, wherein
the first and second semiconductor patterns include a two-dimensional material doped with an N-type, and
the thin layer structure includes nitride.

14. The semiconductor device of claim 11, wherein
the first and second semiconductor patterns include a two-dimensional material doped with P type, and
the thin layer structure includes oxide.

15. The semiconductor device of claim 11, wherein
the first and second semiconductor patterns include a two-dimensional material, and
the two-dimensional material includes at least one of graphene, a transition metal chalcogenide, black phosphorus, or a two-dimensional oxide.
